# EUROPEAN PATENT APPLICATION

(11) **EP 4 727 277 A1**
(43) Date of publication of application: **15.04.2026**
(21) Application number: 25207413.3
(22) Date of filing: 08.10.2025
(51) Int. Cl.: H05K 7/20

(54) **POWER CONVERSION DEVICE**

(30) Priority: 09.10.2024 CN 202411406301
(71) Applicant: Huawei Digital Power Technologies Co., Ltd., Shenzhen, Guangdong 518043 (CN)
(72) Inventor: REN, Junheng, Shenzhen, Guangdong, 518043 (CN); LI, Jiyang, Shenzhen, Guangdong, 518043 (CN)
(74) Representative: Maiwald GmbH

(57) **Abstract**

Embodiments of this application provide a power conversion device, and relate to the field of energy technologies. The power conversion device includes a housing, a power module, and a heat dissipator. The heat dissipator includes a base plate, a heat dissipation tube, a first protection plate, and a liquid injection tube. A gas-liquid channel is provided in the base plate, a cooling medium for gas-liquid conversion is provided in the gas-liquid channel, the heat dissipation tube is fastened to a plate surface of the base plate, and an internal channel of the heat dissipation tube is in communication with the gas-liquid channel. The housing has a mounting opening, the base plate and the heat dissipation tube are both located outside the housing, and the power module passes through the mounting opening to be in contact with a plate surface that is of the base plate and that faces away from the heat dissipation tube, or the base plate is located inside the housing and is in contact with the power module, and the heat dissipation tube passes through the mounting opening to extend out of the housing. The first protection plate and the heat dissipation tube are arranged in a first direction, and the first direction is perpendicular to a thickness direction of the base plate. An internal channel of the liquid injection tube is in communication with the gas-liquid channel, and the liquid injection tube is at least partially located between the first protection plate and the heat dissipation tube. According to the foregoing technical solution, a possibility of damage to the liquid injection tube can be reduced.

## Description

### TECHNICAL FIELD

This application relates to the field of energy technologies, and in particular, to a power conversion device.

### BACKGROUND

In recent years, a demand for heat dissipation of power conversion devices has increased dramatically. To implement heat dissipation of a power module inside a power conversion device, a two-phase heat dissipator has received increasing attention. The two-phase heat dissipator implements efficient heat dissipation through phase change of working fluid. Because two-phase working fluid needs to be injected into the heat dissipator, a liquid injection tube needs to be reserved, and the liquid injection tube needs to be sealed after liquid injection is completed.

In the conventional technology, for ease of liquid injection, a liquid injection tube is usually disposed close to an outer side of a heat dissipator. In this case, the liquid injection tube may be damaged due to collision during mounting and transportation of the heat dissipator.

### SUMMARY

This application provides a power conversion device, so that a possibility of damage to a liquid injection tube can be reduced during mounting and transportation of a heat dissipator, to prolong a service life of the heat dissipator.

To achieve the foregoing objective, the following technical solutions are used in this application.

This application provides a power conversion device. The power conversion device includes a housing, a power module, and a heat dissipator, where the housing is configured to accommodate the power module, and the power module is configured to convert a direct current from a photovoltaic module or an energy storage battery into an alternating current; the heat dissipator includes a base plate, a heat dissipation tube, a first protection plate, and a liquid injection tube; the base plate is fastened to the housing, a gas-liquid channel is provided in the base plate, a cooling medium for gas-liquid conversion is provided in the gas-liquid channel, the heat dissipation tube is fastened to a plate surface of the base plate, and an internal channel of the heat dissipation tube is in communication with the gas-liquid channel; the housing has a mounting opening, the base plate and the heat dissipation tube are both located outside the housing, and the power module passes through the mounting opening to be in contact with a plate surface that is of the base plate and that faces away from the heat dissipation tube, or the base plate is located inside the housing and is in contact with the power module, and the heat dissipation tube passes through the mounting opening to extend out of the housing; the first protection plate and the heat dissipation tube are fastened to the same plate surface of the base plate, the first protection plate and the heat dissipation tube are arranged in a first direction, and the first direction is perpendicular to a thickness direction of the base plate; and an end of the liquid injection tube is fastened to the base plate, an internal channel of the liquid injection tube is in communication with the gas-liquid channel, and the liquid injection tube is at least partially located between the first protection plate and the heat dissipation tube.

The power module is a component that generates heat badly in the power conversion device. The heat dissipator dissipates heat from the power module, making heat dissipation efficiency of the power conversion device higher. A heat dissipation principle of the heat dissipator is as follows: A liquid cooling medium accumulates in the base plate. The liquid cooling medium changes into a gas cooling medium when heated by the power module. The gas cooling medium at least partially flows into the heat dissipation tube. Because the heat dissipation tube is entirely or partially located outside the housing, the heat dissipation tube can exchange heat with air outside the housing, and the gas cooling medium in the heat dissipation tube cools down and then changes back into a liquid cooling medium. The liquid cooling medium at least partially flows back into the base plate, continues to absorb heat of the power module, changes into a gas cooling medium again, and then dissipates heat in the heat dissipation tube. This cycle is repeated to implement uninterrupted heat dissipation of the power module. Because the cooling medium needs to be injected from the outside into the base plate, the liquid injection tube is in communication with the base plate, and the cooling medium may be injected into the gas-liquid channel of the base plate through the liquid injection tube. The liquid injection tube is at least partially disposed between the first protection plate and the heat dissipation tube, so that the liquid injection tube can be protected by using the first protection plate, reducing a possibility of damage to the liquid injection tube during mounting and transportation of the heat dissipator.

In an optional implementation, the liquid injection tube is located between the first protection plate and the heat dissipation tube, the first protection plate has an opening, and the opening passes through the first protection plate in the first direction.

In a case that liquid needs to be injected into the base plate through the liquid injection tube, the liquid injection tube between the first protection plate and the heat dissipation tube may be pulled out, and the pulled-out liquid injection tube can pass through the opening and extend to a side that is of the first protection plate and that faces away from the heat dissipation tube. Alternatively, a part of the initially mounted liquid injection tube extends to a side that is of the first protection plate and that faces away from the heat dissipation tube. A cooling medium (the cooling medium that can undergo gas-liquid conversion) can be injected into the gas-liquid channel of the base plate through liquid injection into the liquid injection tube. After the liquid injection is completed, a port of the liquid injection tube is sealed, and then the liquid injection tube is adjusted back to a position between the first protection plate and the heat dissipation tube, so that a liquid injection operation on the heat dissipator is completed. The liquid injection tube located between the first protection plate and the heat dissipation tube is protected by the first protection plate, resulting in a low risk of damage.

In an optional implementation, the opening directly faces the liquid injection tube in the first direction.

The opening directly facing the liquid injection tube facilitates the adjustment of the liquid injection tube to a position between the first protection plate and the heat dissipation tube after the operation of liquid injection into the base plate through the liquid injection tube is completed, reducing difficulty in bending the liquid injection tube.

In an optional implementation, a distance between the base plate and an edge that is of the opening and that faces away from the base plate is greater than a distance between the base plate and an end portion that is of the liquid injection tube and that faces away from the base plate.

In some cases, the liquid injection tube is a hard tube body (for example, a metal tube), so that flexibility of the liquid injection tube is poor. In this case, the edge that is of the opening and that faces away from the base plate is farther away from the base plate than the end portion of the liquid injection tube. This helps retract the liquid injection tube from the opening to a position between the first protection plate and the heat dissipation tube, reducing a possibility of interference from the first protection plate on movement of the liquid injection tube.

In an optional implementation, the heat dissipator further includes a baffle plate, the baffle plate is fastened to the first protection plate, and the baffle plate is configured to seal the opening.

After the liquid injection tube is adjusted to a position between the first protection plate and the heat dissipation tube, the baffle plate is mounted on the first protection plate, and the opening on the first protection plate is covered by the baffle plate, to seal the opening. The cooperation between the baffle plate and the first protection plate further protects the liquid injection tube, reducing a possibility of damage to the liquid injection tube.

In an optional implementation, the first protection plate has an opening, the opening passes through the first protection plate in the first direction, one part of the liquid injection tube is located between the first protection plate and the heat dissipation tube, and the other part of the liquid injection tube passes through the opening to extend to a side that is of the first protection plate and that faces away from the liquid injection tube.

In other words, the liquid injection tube always passes through the opening and extends to a side that is of the first protection plate and that faces away from the heat dissipation tube. A cooling medium (the cooling medium that can undergo gas-liquid conversion) can be injected into the gas-liquid channel of the base plate through liquid injection into the liquid injection tube. After the liquid injection is completed, a tube opening of the liquid injection tube is sealed without adjusting the liquid injection tube back to a position between the first protection plate and the heat dissipation tube, reducing processing steps and improving production efficiency. In the foregoing case, a part of the liquid injection tube is located between the first protection plate and the heat dissipation tube, so that a possibility of damage to the liquid injection tube can also be reduced under the protection of the first protection plate.

In an optional implementation, the heat dissipator further includes a protective cover, the protective cover is fastened to the first protection plate, the protective cover is at least partially located on a side that is of the first protection plate and that faces away from the heat dissipation tube, and the part that is of the liquid injection tube and that extends to the side that is of the first protection plate and that faces away from the liquid injection tube is located in the protective cover.

After the liquid injection is completed, a tube opening of the liquid injection tube is sealed, and the protective cover is mounted on the first protection plate, so that the part that is of the liquid injection tube and that is located on the side that is of the first protection plate and that faces away from the heat dissipation tube is protected by the protective cover. In this way, the part that is of the liquid injection tube and that is located between the first protection plate and the heat dissipation tube is protected by the first protection plate, and the part that is of the liquid injection tube and that is located on the side that is of the first protection plate and that faces away from the heat dissipation tube is protected by the protective cover. The cooperation between the first protection plate and the protective cover further reduces a risk of damage to the liquid injection tube.

In an optional implementation, the first protection plate has two opposite edges in a second direction, and the first direction, the second direction, and the thickness direction of the base plate are perpendicular to each other; and the opening extends to one of the edges of the first protection plate, and the liquid injection tube is closer to the edge, from the two edges of the first protection plate, at which the opening is provided.

The opening extends to one of the edges of the first protection plate in the second direction, that is, the opening passes through one of the edges of the first protection plate, facilitating mounting of the first protection plate on an outer side of the liquid injection tube. In addition, in a case that the liquid injection tube needs to be adjusted to a position between the first protection plate and the heat dissipation tube, the opening passes through the edge of the first protection plate, so that the liquid injection tube can also be twisted to the position between the first protection plate and the heat dissipation tube through the edge that is of the first protection plate and through which the opening passes, making it more convenient to twist or bend the liquid injection tube.

In an optional implementation, the heat dissipator further includes first fins, the first fins are fastened between the first protection plate and the heat dissipation tube, and the first fins avoid the liquid injection tube.

The first fins can help the heat dissipation tube to dissipate heat. After heat is transferred to the heat dissipation tube and the first protection plate, heat of the heat dissipation tube and the first protection plate can also be transferred to the first fins and exchanged with outside air through the first fins, further improving heat dissipation efficiency of the heat dissipator. In addition, the first fins avoid the liquid injection tube, so that a possibility of mutual interference between the first fins and the liquid injection tube can be reduced, facilitating assembly of the heat dissipator.

In an optional implementation, the heat dissipation tube includes a plurality of heat dissipation sub-tubes and a plurality of second fins, the plurality of heat dissipation sub-tubes are arranged in the first direction, a gap is provided between two adjacent heat dissipation sub-tubes, and the plurality of second fins are fastened between at least two adjacent heat dissipation sub-tubes.

The gaps between the plurality of heat dissipation sub-tubes allow for full heat exchange between the heat dissipation tube and air. In addition, the second fins can help the heat dissipation sub-tubes to dissipate heat. After heat is transferred to the heat dissipation tube, heat of the heat dissipation sub-tubes can be transferred to the second fins and exchanged with outside air through the second fins, further improving heat dissipation efficiency of the heat dissipator.

In an optional implementation, the heat dissipator further includes a second protection plate, the second protection plate and the first protection plate are fastened to the same plate surface of the base plate, and the heat dissipation tube is located between the first protection plate and the second protection plate in the first direction.

The first protection plate and the second protection plate are located on two sides of the heat dissipation tube to protect the heat dissipation tube together, reducing a possibility of damage to the heat dissipation tube. In addition, the first protection plate can also provide protection for the liquid injection tube when protecting the heat dissipation tube.

In an optional implementation, the heat dissipator further includes a flow convergence plate. The heat dissipation tube is located between the base plate and the flow convergence plate. A flow convergence cavity is provided in the flow convergence plate. The flow convergence cavity is in communication with the internal channel of the heat dissipation tube.

The flow convergence plate may be of a hollow plate structure. One end of the heat dissipation tube is in communication with the gas-liquid channel, and the other end is in communication with the flow convergence cavity. A gas cooling medium in the heat dissipation tube can flow into the flow convergence plate and change into a liquid cooling medium in the flow convergence plate. In addition, after a gas cooling medium in the heat dissipation tube changes into a liquid cooling medium, the liquid cooling medium can also flow into the flow convergence plate. The liquid cooling medium in the flow convergence plate accumulates at a bottom portion of the flow convergence plate and then flows back into the base plate from the heat dissipation tube.

### BRIEF DESCRIPTION OF DRAWINGS

FIG. 1 is a diagram of a structure of a photovoltaic system according to an embodiment of this application;
FIG. 2 is a diagram of an external structure of a power conversion device according to an embodiment of this application;
FIG. 3 is a diagram of an internal structure of a power conversion device according to an embodiment of this application;
FIG. 4 is a diagram of a split structure of a power conversion device according to an embodiment of this application;
FIG. 5 is a diagram of an internal structure of another power conversion device according to an embodiment of this application;
FIG. 6 is a diagram of a structure of a heat dissipator according to an embodiment of this application;
FIG. 7 is a diagram of a position relationship between a power module and a heat dissipator according to an embodiment of this application;
FIG. 8 is a diagram of a structure of a liquid injection tube according to an embodiment of this application;
FIG. 9 is a diagram of a position relationship between a liquid injection tube and a heat dissipation tube according to an embodiment of this application;
FIG. 10 is a diagram of a structure of an opening according to an embodiment of this application;
FIG. 11 is a diagram of a structure of a baffle plate according to an embodiment of this application;
FIG. 12 is a diagram of a structure of a snap-fitting groove according to an embodiment of this application;
FIG. 13 is a diagram of a structure of another liquid injection tube according to an embodiment of this application;
FIG. 14 is a diagram of a structure of a protective cover according to an embodiment of this application;
FIG. 15 is a diagram of a structure of a second protection plate according to an embodiment of this application;
FIG. 16 is a diagram of a structure of first fins according to an embodiment of this application;
FIG. 17 is a diagram of a position relationship between first fins and a liquid injection tube according to an embodiment of this application; and
FIG. 18 is a diagram of an internal structure of still another power conversion device according to an embodiment of this application.

Reference numerals:
100: photovoltaic system; 101: power conversion device; 102: photovoltaic module; 103: switch box; 104: box-type transformer station; 105: power grid; 1: housing; 11: mounting opening; 12: air inlet; 13: air outlet; 2: power module; 3: circuit board; 31: some other electronic components; 32: inductor; 4: heat exchanger; 5: heat dissipator; 51: base plate; 511: gas-liquid channel; 512: cooling medium; 52: heat dissipation tube; 521: heat dissipation sub-tube; 5211: flow channel; 522: second fin; 53: flow convergence plate; 531: flow convergence cavity; 54: first protection plate; 541: opening; 55: liquid injection tube; 56: baffle plate; 561: snap-fitting groove; 57: protective cover; 58: second protection plate; 59: first fin; 50: third fin; 6: air blowing structure; 7: heat dissipation cover; 71: air intake vent; 72: air exhaust vent.

### DESCRIPTION OF EMBODIMENTS

The following describes technical solutions in embodiments of this application with reference to the accompanying drawings in embodiments of this application. It is clear that the described embodiments are merely some rather than all of embodiments of this application.

In the accompanying drawings in embodiments of this application, entity structures such as components and assemblies are represented by using guide lines, and hollowed-out structures such as openings, holes, space, and cavities are represented by using guide lines with arrows.

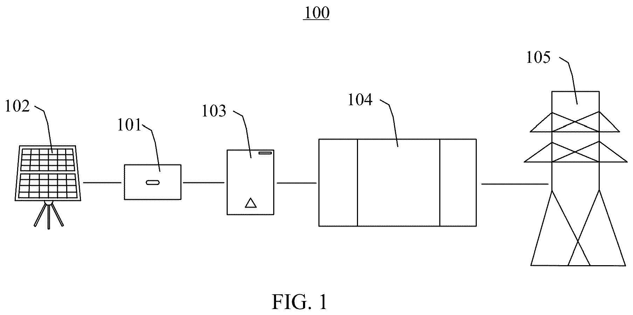

An embodiment of this application provides a power conversion device 101. In an example, the power conversion device 101 may be an inverter. In this example, the power conversion device 101 is used in a photovoltaic system 100. FIG. 1 shows an example of a structure of the photovoltaic system 100. Refer to FIG. 1. A photovoltaic module 102 directly converts solar energy into electric energy based on photovoltaic effect. The photovoltaic module 102 usually includes a plurality of (where the "plurality of" in this application means two or more) cells connected in series or in parallel, to reach specific rated output power and voltage. The power conversion device 101 (for example, a photovoltaic inverter) is configured to convert a direct current from the photovoltaic module 102 into an alternating current. The alternating current is sent to a box-type transformer station 104 for voltage transformation after passing through a switch box 103 for on-off control, and is output to a power grid 105 or another load.

In another example, the power conversion device 101 may be a power conversion system (PCS). In this example (not shown in the figure), the power conversion device 101 is used in an energy storage system. A direct current source of the power conversion device 101 includes an energy storage battery. The power conversion device 101 is configured to convert a direct current from the energy storage battery into an alternating current, and output the alternating current to the power grid 105 or another load. In addition, the power conversion device 101 (the power conversion system) can further convert an alternating current from the power grid 105 into a direct current to charge the energy storage battery.

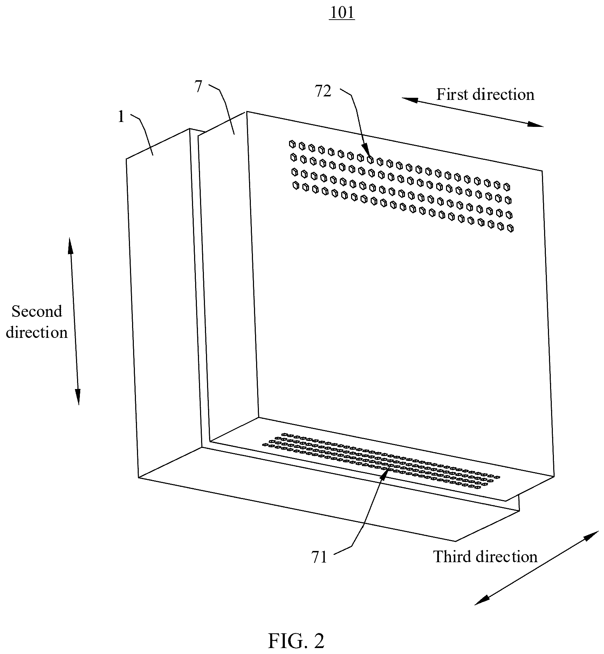

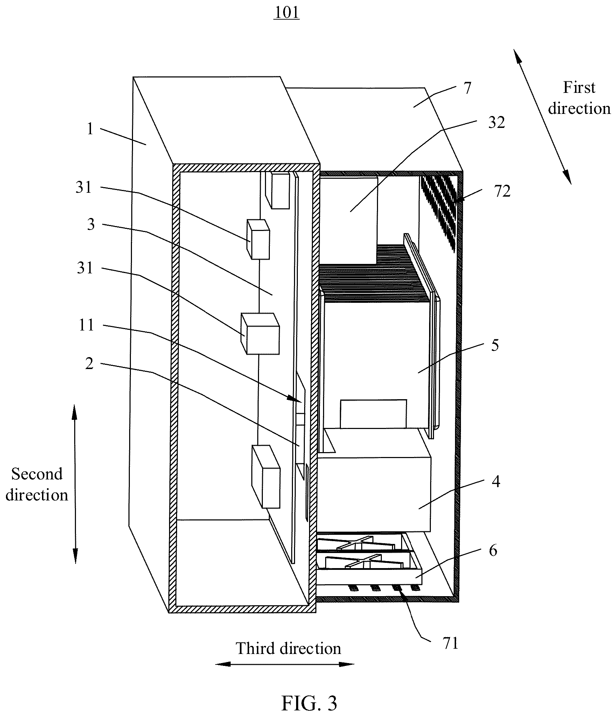

FIG. 2 shows an example of an external structure of the power conversion device 101. FIG. 3 shows an example of an internal structure of the power conversion device 101 in FIG. 2. Refer to FIG. 2 and FIG. 3. The power conversion device 101 includes a housing 1, a circuit board 3, and a power module 2. There is space inside the housing 1 for placing components and apparatuses. The circuit board 3 may be a printed circuit board (PCB). The circuit board 3 is fastened in the internal space of the housing 1. The power module 2 is configured to convert a direct current from the photovoltaic module 102 or the energy storage battery into an alternating current. The power module 2 is located in the housing 1 and is fastened to the circuit board 3. In other words, both the circuit board 3 and the power module 2 are located in the housing 1.

In some examples, there is one power module 2. In some other examples, there are a plurality of power modules 2. FIG. 3 shows one power module 2 on the circuit board 3, and the power module 2 is used as an example for subsequent description.

Moreover, in addition to the power module 2, the circuit board 3 may be provided with some other electronic components 31 (a capacitor, an inductor, and the like), for example, structures indicated by the number 31 in FIG. 3. In some examples, the foregoing some other electronic components 31 and the power module 2 may be disposed on different board surfaces of the circuit board 3. For example, with reference to FIG. 3, the power module 2 is disposed on one board surface of the circuit board 3, and the foregoing some other electronic components 31 are disposed on the other board surface of the circuit board 3. In some other examples, the foregoing some other electronic components 31 and the power module 2 may be disposed on a same board surface of the circuit board 3. In some other examples, some electronic components of the foregoing some other electronic components 31 and the power module 2 are disposed on a same board surface of the circuit board 3, and the other electronic components and the power module 2 are disposed on different board surfaces of the circuit board 3. This is not specifically limited in this application.

In some examples, an electronic component that generates heat badly, for example, an inductor 32, may be disposed outside the housing 1 and fastened to the housing 1, for the electronic component that generates heat badly to dissipate heat outside the housing 1. An electronic component (for example, the inductor 32 in FIG. 3) outside the housing 1 is electrically connected to the circuit board 3 by a lead wire (not shown in the figure).

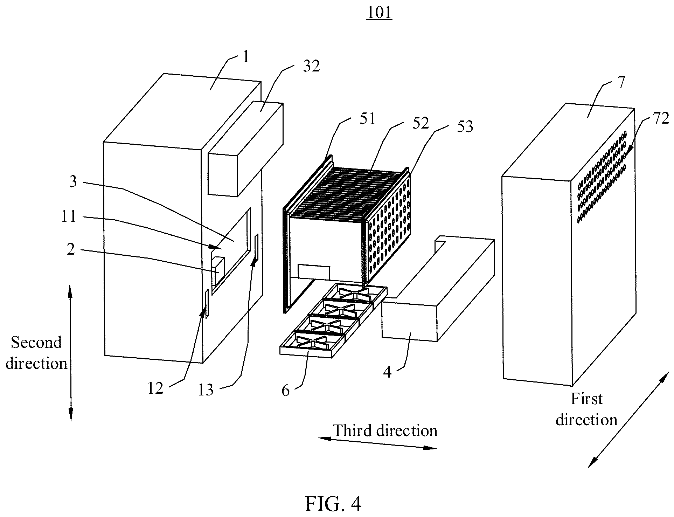

To cool down the inside of the housing 1, in some examples, the power conversion device 101 further includes a heat exchanger 4. The heat exchanger 4 is disposed outside the housing 1 and is fastened to a side wall of the housing 1. A heat exchange channel is provided inside the heat exchanger 4. FIG. 4 shows an example structure of a split structure of the power conversion device 101. Refer to FIG. 4. An air inlet 12 and an air outlet 13 are provided on the housing 1. One end of the heat exchange channel of the heat exchanger 4 is in communication with the air inlet 12, and the other end is in communication with the air outlet 13. A driving member (such as a fan or an air blower) may be further disposed in the housing 1. The driving member is not shown in the figures of this application. By using the driving member, air in the housing 1 can be sent from the air inlet 12 into the heat exchanger 4, exchange heat in the heat exchanger 4 with air outside the housing 1, and then be exhausted from the air outlet 13 and return to the housing 1, to cool down the inside of the housing 1. In some other examples, the power conversion device 101 may not include the heat exchanger 4.

In addition, the power module 2 is a component that generates heat badly in the power conversion device 101. Refer to FIG. 3 and FIG. 4. The power conversion device 101 further includes a heat dissipator 5. The heat dissipator 5 can provide targeted heat dissipation for the power module 2, thereby enhancing heat dissipation efficiency of the power conversion device 101. In a case that the power conversion device 101 further includes the heat exchanger 4, the heat exchanger 4 and the heat dissipator 5 are misaligned in a second direction. For the heat dissipator 5 to be in contact with the power module 2, a mounting opening 11 is provided on the housing 1, and the power module 2 is located on a board surface that is of the circuit board 3 and that faces the mounting opening 11.

In an example, with reference to FIG. 3, the heat dissipator 5 is located outside the housing 1, and the power module 2 passes through the mounting opening 11 to be in contact with the heat dissipator 5 (or is fastened to the heat dissipator 5). It needs to be noted that, in this example, the power module 2 is also disposed in the housing 1. For example, the heat dissipator 5 is closely attached to a side wall that is of the housing 1 and on which the mounting opening 11 is provided, and the heat dissipator 5 seals the mounting opening 11. That the power module 2 passes through the mounting opening 11 does not mean that the power module 2 passes through the mounting opening 11 and extends out of the housing 1, but means that the power module 2 extends to the mounting opening 11, and a contact position between the power module 2 and the heat dissipator 5 is at the mounting opening 11.

Refer to FIG. 3 and FIG. 4. The heat dissipator 5 includes a base plate 51 and a heat dissipation tube 52. Both the base plate 51 and the heat dissipation tube 52 are located outside the housing 1. The base plate 51 is fastened to the housing 1 and seals the mounting opening 11. The power module 2 is in contact with or connected to the base plate 51. The heat dissipation tube 52 is fastened to a plate surface that is of the base plate 51 and that faces away from the power module 2.

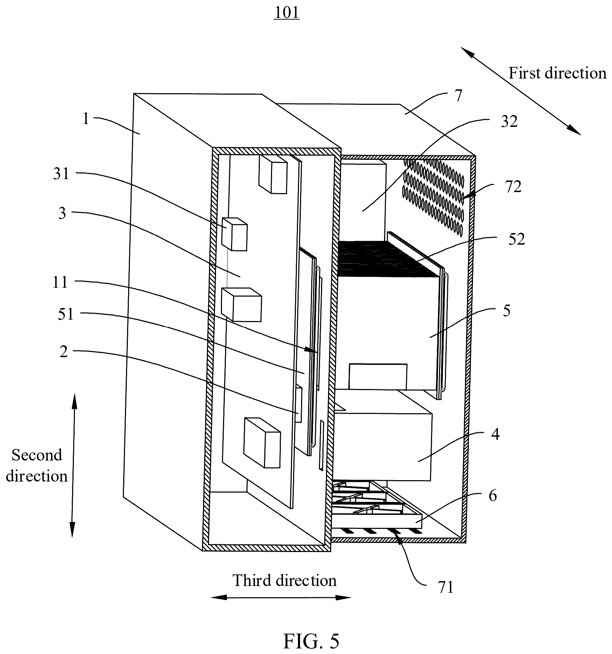

In some other examples, one part of the heat dissipator 5 may be located inside the housing 1 and in contact with the power module 2, and the other part extends out of the housing 1. For example, FIG. 5 shows an example of an internal structure of another power conversion device 101. Refer to FIG. 5. A base plate 51 is located in a housing 1 and is in contact with a power module 2, and a heat dissipation tube 52 passes through a mounting opening 11 to extend out of the housing 1.

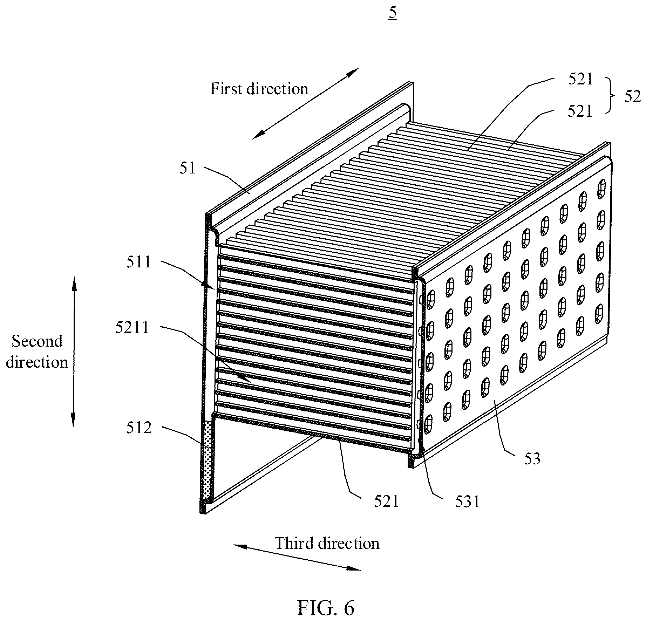

FIG. 6 shows an example of a structure of a heat dissipator 5. Refer to FIG. 6. The base plate 51 may be of a hollow plate structure. A gas-liquid channel 511 is provided in the base plate 51. A cooling medium 512 for gas-liquid conversion is provided in the gas-liquid channel 511. The heat dissipation tube 52 is fastened to a plate surface of the base plate 51. An internal channel of the heat dissipation tube 52 is in communication with the gas-liquid channel 511. In the example shown in FIG. 6, the heat dissipation tube 52 includes a plurality of heat dissipation sub-tubes 521, and the plurality of heat dissipation sub-tubes 521 are arranged in a first direction. The first direction is perpendicular to a thickness direction of the base plate 51 (a third direction). Each heat dissipation sub-tube 521 is a flat tube. A plurality of flow channels 5211 are provided in each heat dissipation sub-tube 521. Each flow channel 5211 is in communication with the gas-liquid channel 511. In other words, the internal channel of the heat dissipation tube 52 includes the plurality of flow channels 5211 of each heat dissipation sub-tube 521, or a plurality of flow channels 5211 of the plurality of heat dissipation sub-tubes 521 together form the internal channel of the heat dissipation tube 52.

In the example shown in FIG. 6, each heat dissipation sub-tube 521 is a microchannel flat tube (where the heat dissipation sub-tube 521 includes a plurality of flow channels 5211). In some other examples, each heat dissipation sub-tube 521 is a single-channel flat tube, and there is only one flow channel 5211 inside this type of heat dissipation sub-tube 521. In some other examples, the heat dissipation tube 52 may alternatively be a whole tube.

The cooling medium 512 can be converted between a gas state and a liquid state. A liquid cooling medium 512 is stored in the gas-liquid channel 511 of the base plate 51. The liquid cooling medium 512 changes into a gas cooling medium 512 when heated by the power module 2. The gas cooling medium 512 at least partially flows into the heat dissipation tube 52. Because the heat dissipation tube 52 is entirely or partially located outside the housing 1, the heat dissipation tube 52 can exchange heat with air outside the housing 1, and the gas cooling medium 512 in the heat dissipation tube 52 cools down and then changes back into a liquid cooling medium 512. The liquid cooling medium 512 flows back into the base plate 51, absorbs heat of the power module 2, changes into a gas cooling medium 512 again, and then flows into the heat dissipation tube 52 to dissipate heat. This cycle is repeated to implement uninterrupted heat dissipation of the power module 2.

In some examples, for the liquid cooling medium 512 to flow back into the base plate 51 more, the heat dissipator 5 may further include a flow convergence plate 53. The heat dissipation tube 52 is located between the base plate 51 and the flow convergence plate 53. The flow convergence plate 53 may be of a hollow plate structure. A flow convergence cavity 531 is provided in the flow convergence plate 53. The flow convergence cavity 531 is in communication with the internal channel of the heat dissipation tube 52. In other words, one end of the heat dissipation tube 52 in the third direction is in communication with the gas-liquid channel 511, and the other end is in communication with the flow convergence cavity 531. A gas cooling medium 512 in the heat dissipation tube 52 can flow into the flow convergence plate 53 and change into a liquid cooling medium 512 in the flow convergence plate 53. In addition, after a gas cooling medium 512 in the heat dissipation tube 52 changes into a liquid cooling medium, the liquid cooling medium can also flow into the flow convergence plate 53. The liquid cooling medium 512 in the flow convergence plate 53 accumulates at a bottom portion of the flow convergence plate 53 and then flows back into the base plate 51 from the heat dissipation tube 52.

In some other examples (not shown in the figures), the heat dissipation tube 52 may alternatively be disposed obliquely, so that the cooling medium 512 in a liquid state inside the heat dissipation tube 52 can smoothly flow back to the base plate 51.

Refer back to FIG. 3 and FIG. 4. To facilitate heat exchange between the heat dissipator 5 and air outside the housing 1, the power conversion device 101 may further include an air blowing structure 6 (such as a fan or an air blower). The air blowing structure 6 is located outside the housing 1, and the air blowing structure 6 can blow air toward the heat dissipator 5. In an example in which the power conversion device 101 further includes the heat exchanger 4, the air blowing structure 6 can also blow air to the heat exchanger 4, to cool down the heat dissipator 5 and the heat exchanger 4. For example, after the power conversion device 101 is mounted, the air blowing structure 6 is located below the heat dissipator 5 and the heat exchanger 4. In some other examples, the power conversion device 101 may not include the air blowing structure 6.

In addition, refer to FIG. 3 and FIG. 4. The power conversion device 101 may further include a heat dissipation cover 7. The heat dissipation cover 7 is located outside the housing 1 and covers the heat dissipator 5, the heat exchanger 4, and the air blowing structure 6. The heat dissipation cover 7 may be provided with an air intake vent 71 and an air exhaust vent 72. The air blowing structure 6 is closer to the air intake vent 71. The heat dissipator 5 and the heat exchanger 4 are located between the air intake vent 71 and the air exhaust vent 72. With reference to FIG. 6, air blown from the air intake vent 71 into the heat dissipation cover 7 flows between two adjacent heat dissipation sub-tubes 521, and then is blown out from the air exhaust vent 72.

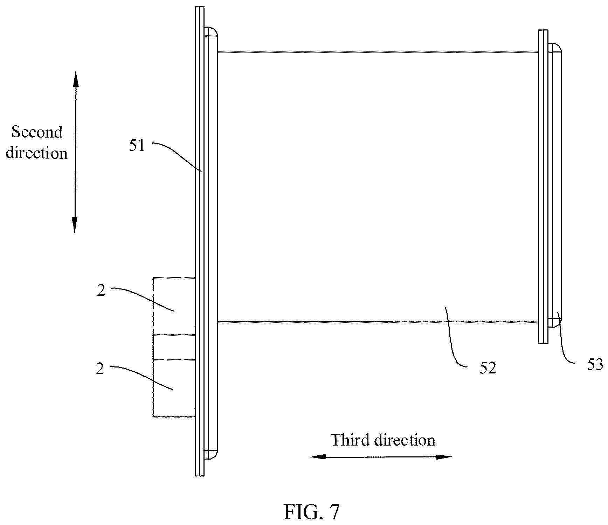

FIG. 7 shows an example of a position relationship between the power module 2 and the heat dissipator 5. In FIG. 7, the second direction is perpendicular to the first direction (with reference to FIG. 6), and the second direction is also perpendicular to the thickness direction of the base plate 51 (the third direction). For example, when the power conversion device 101 is mounted at a specified position and is in a use state, the second direction may be a gravity direction. In some examples, the base plate 51 protrudes downward from the heat dissipation tube 52 in the second direction. After the heat dissipator 5 is mounted on the housing 1, the power module 2 is connected to the base plate 51 of the heat dissipator 5, and the power module 2 (the power module 2 indicated by a solid box) may be entirely located below the heat dissipation tube 52. In some other examples, one part of the power module 2 (the power module 2 indicated by a dashed box) is located below the heat dissipation tube 52, and the other part overlaps the heat dissipation tube 52 in the third direction.

In some other examples, the base plate 51 does not apparently protrude downward from the heat dissipation tube 52. In this example, the power module 2 is not located below the heat dissipation tube 52, and the power module 2 in this example overlaps the heat dissipation tube 52 in the third direction.

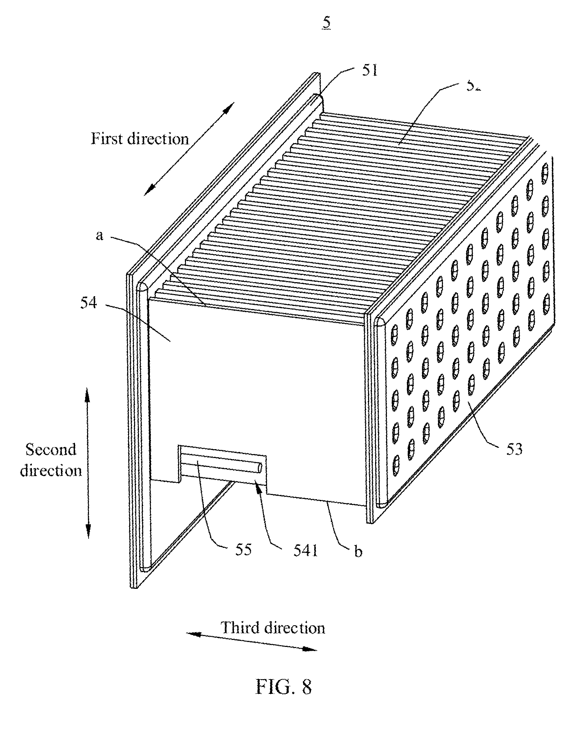

Because the cooling medium 512 needs to be injected from the outside into the base plate 51, the heat dissipator 5 further includes a liquid injection tube 55. FIG. 8 shows an example of a structure of the liquid injection tube 55. The liquid injection tube 55 may be a metal tube, or the liquid injection tube 55 may be a plastic tube or a rubber tube. This is not specifically limited in this application. An end of the liquid injection tube 55 is fastened to the base plate 51. An internal channel of the liquid injection tube 55 is in communication with the gas-liquid channel 511 of the base plate 51. The cooling medium 512 may be injected into the gas-liquid channel 511 of the base plate 51 through the liquid injection tube 55. After the liquid injection is completed, a port of the liquid injection tube 55 may be sealed, reducing a possibility of leakage of the cooling liquid in the base plate 51 from the liquid injection tube 55.

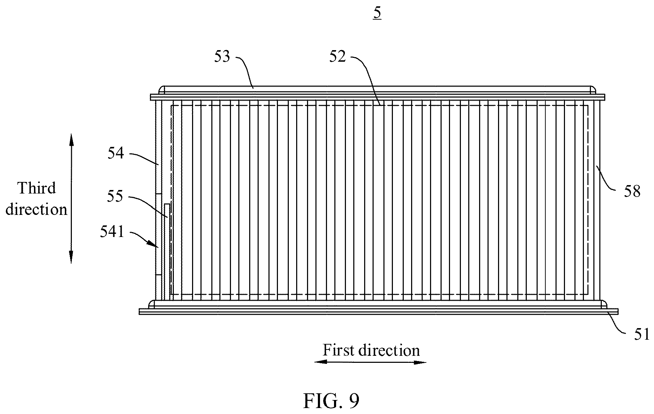

In addition, the heat dissipator 5 further includes a first protection plate 54. The first protection plate 54 and the heat dissipation tube 52 are fastened to the same plate surface of the base plate 51. The first protection plate 54 and the heat dissipation tube 52 are arranged in the first direction. The liquid injection tube 55 is at least partially located between the first protection plate 54 and the heat dissipation tube 52. For example, FIG. 9 shows an example of a position relationship between the liquid injection tube 55 and the heat dissipation tube 52. The liquid injection tube 55 is entirely located between the first protection plate 54 and the heat dissipation tube 52. The first protection plate 54 may be a hard plate. For example, the first protection plate 54 may be a metal plate, a plastic plate, or another solid plate structure. The liquid injection tube 55 is disposed between the first protection plate 54 and the heat dissipation tube 52, so that the liquid injection tube 55 can be protected by using the first protection plate 54, reducing a possibility of damage to the liquid injection tube 55 during mounting and transportation of the heat dissipator 5.

Refer back to FIG. 8. In the example in which the liquid injection tube 55 is located between the first protection plate 54 and the heat dissipation tube 52, the first protection plate 54 has an opening 541, and the opening 541 may be a square opening, a circular opening, or an irregularly shaped opening. The opening 541 passes through the first protection plate 54 in the first direction. The opening 541 directly faces the liquid injection tube 55 in the first direction. That the opening 541 directly faces the liquid injection tube 55 means that the opening 541 can expose the liquid injection tube 55 in the first direction. In this way, the liquid injection tube 55 can be pulled from the opening 541 to a side that is of the first protection plate 54 and that faces away from the heat dissipation tube 52.

In a case that liquid needs to be injected into the base plate 51 through the liquid injection tube 55, the liquid injection tube 55 between the first protection plate 54 and the heat dissipation tube 52 may be pulled out, the pulled-out liquid injection tube 55 can pass through the opening 541, and a pulled-out part of the liquid injection tube 55 extends to the side that is of the first protection plate 54 and that faces away from the heat dissipation tube 52. The cooling medium 512 can be injected into the base plate 51 through liquid injection into the liquid injection tube 55. After the liquid injection is completed, a port of the liquid injection tube 55 is sealed, and then the liquid injection tube 55 is adjusted (for example, bent or twisted) back to a position between the first protection plate 54 and the heat dissipation tube 52, so that a liquid injection operation on the heat dissipator 5 is completed.

The opening 541 may be provided at any appropriate position. For example, with reference to FIG. 8, in the second direction, the first protection plate 54 has two opposite edges: an edge a and an edge b. The opening 541 extends to one of the edges (for example, the edge b in FIG. 8) of the first protection plate 54. In other words, the opening 541 passes through one of the edges (the edge b) of the first protection plate 54. The liquid injection tube 55 is closer to the edge, from the two edges of the first protection plate 54, at which the opening 541 is provided, and the opening 541 exposes the liquid injection tube 55. In a case that a position of the liquid injection tube 55 needs to be adjusted, for example, the liquid injection tube 55 needs to be adjusted to a position between the first protection plate 54 and the heat dissipation tube 52, or a part of the liquid injection tube 55 needs to be pulled out to the side that is of the first protection plate 54 and that faces away from the heat dissipation tube 52, the opening 541 passes through the edge of the first protection plate 54, so that a moving path of the liquid injection tube 55 can also pass through the edge that is of the first protection plate 54 and through which the opening 541 passes. In this way, it is easier for the liquid injection tube 55 to move.

In some other examples, the opening 541 extends to the edge a of the first protection plate 54. In other words, the opening 541 passes through the edge a of the first protection plate 54.

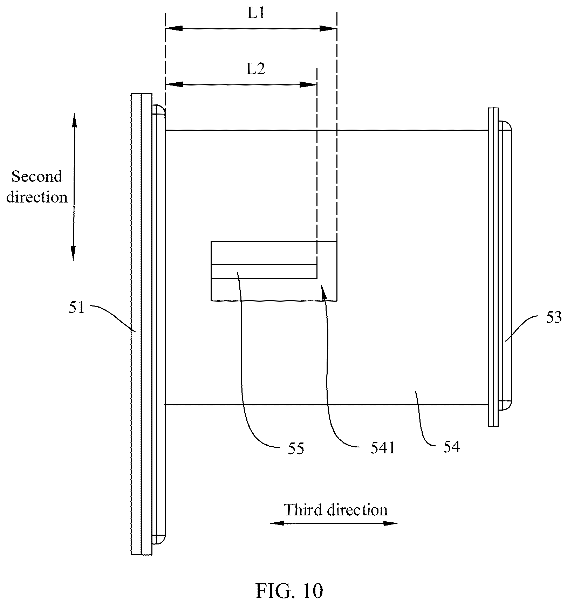

In some other examples, FIG. 10 shows an example of a structure of another opening 541. Refer to FIG. 10. The opening 541 is located in a middle region of the first protection plate 54. In other words, the opening 541 does not extend to any edge of the first protection plate 54. In this example, the opening 541 exposes the liquid injection tube 55, the opening 541 may be a square opening, and a distance (L1) between the base plate 51 and an edge that is of the opening 541 and that faces away from the base plate 51 is greater than a distance (L2) between the base plate 51 and an end portion that is of the liquid injection tube 55 and that faces away from the base plate 51. For example, in a case that the liquid injection tube 55 is a hard tube body (for example, a metal tube), flexibility of the liquid injection tube 55 is poor. The edge that is of the opening 541 and that faces away from the base plate 51 is farther away from the base plate 51 than the end portion of the liquid injection tube 55. This helps retract the liquid injection tube 55 through the opening 541 to a position between the first protection plate 54 and the heat dissipation tube 52, reducing a possibility of interference from the first protection plate 54 on movement of the liquid injection tube 55.

In the example shown in FIG. 10, if a size of the opening 541 can allow for normal movement of the liquid injection tube 55 (for example, the liquid injection tube 55 is bent to a position between the first protection plate 54 and the heat dissipation tube 52), the size of the opening 541 may not be limited. For example, the distance (L1) between the base plate 51 and the edge that is of the opening 541 and that faces away from the base plate 51 may alternatively be less than or equal to the distance (L2) between the base plate 51 and the end portion that is of the liquid injection tube 55 and that faces away from the base plate 51.

For the size of the opening 541, in the example shown in FIG. 8, because the opening extends to the edge of the first protection plate 54, the liquid injection tube 55 can be adjusted from the edge of the first protection plate 54 to a position between the first protection plate 54 and the heat dissipation tube 52, so that adjustment of a bending degree of the liquid injection tube 55 may be independent of the size of the opening 541. Therefore, in the example shown in FIG. 8, the distance between the base plate 51 and the edge that is of the opening 541 and that faces away from the base plate 51 may be less than, equal to, or greater than the distance between the base plate 51 and the end portion that is of the liquid injection tube 55 and that faces away from the base plate 51.

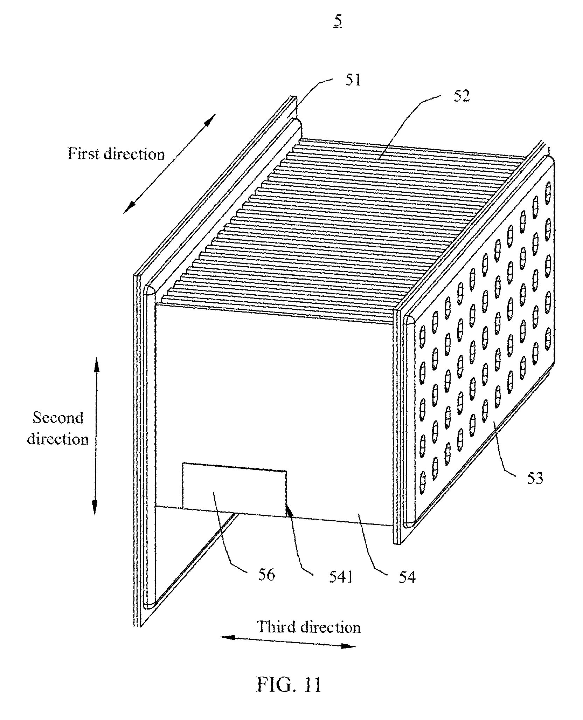

In addition, the heat dissipator 5 may further include a baffle plate 56. FIG. 11 shows an example of a structure of the baffle plate 56. Refer to FIG. 11. The baffle plate 56 is fastened to the first protection plate 54, and the baffle plate 56 is configured to seal the opening 541. The baffle plate 56 is mounted later. To be specific, after liquid injection through the liquid injection tube 55 is completed, the liquid injection tube 55 is adjusted to a position between the first protection plate 54 and the heat dissipation tube 52, then the baffle plate 56 is mounted on the first protection plate 54, and the opening 541 on the first protection plate 54 is covered by the baffle plate 56, to seal the opening 541, further protect the liquid injection tube 55, and reduce a possibility of damage to the liquid injection tube 55.

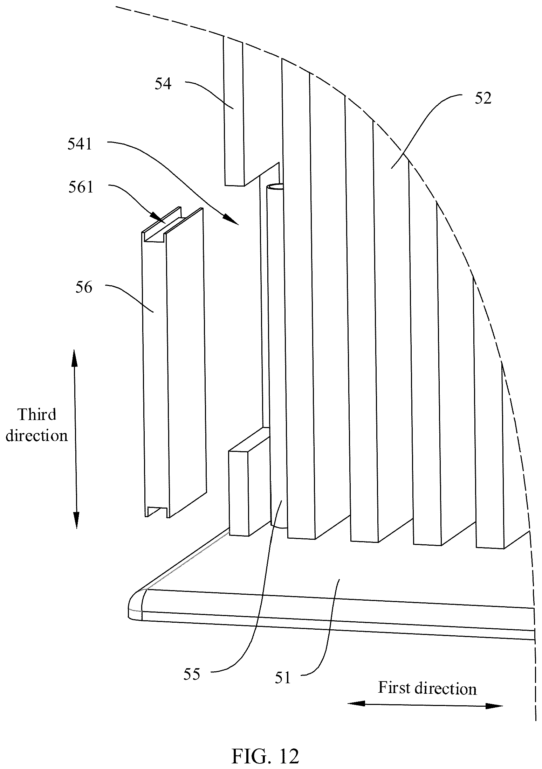

The baffle plate 56 may be of any appropriate structure, and the baffle plate 56 may also be fastened to the opening 541 in any appropriate manner. For example, the baffle plate 56 may be fastened to the first protection plate 54 by a bolt or a screw. In another example, the baffle plate 56 may be bonded or welded to the first protection plate 54. In another example, the baffle plate 56 may be snap-fitted to the first protection plate 54, or the baffle plate 56 may be first snap-fitted to the first protection plate 54 and then reinforced by a bolt. In an example in which the baffle plate 56 is snap-fitted to the first protection plate 54, a snap-fitting groove 561 is provided on the baffle plate 56. FIG. 12 shows an example of a structure of the snap-fitting groove 561. After the baffle plate 56 is mounted on the first protection plate 54, a part that is of the first protection plate 54 and that encloses the opening 541 is snap-fitted the snap-fitting groove 561, to fasten the baffle plate 56.

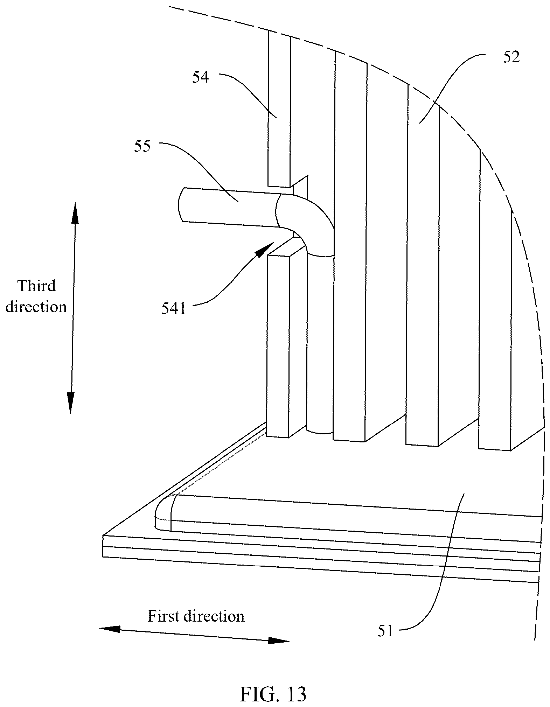

In another example, the liquid injection tube 55 is not entirely located between the first protection plate 54 and the heat dissipation tube 52. Instead, one part of the liquid injection tube 55 is located between the first protection plate 54 and the heat dissipation tube 52, and the other part is located on a side that is of the first protection plate 54 and that faces away from the heat dissipation tube 52. For example, FIG. 13 shows an example of a structure of another liquid injection tube 55. The liquid injection tube 55 is bent. The first protection plate 54 has an opening 541. The opening 541 passes through the first protection plate 54 in the first direction. One part of the liquid injection tube 55 is located between the first protection plate 54 and the heat dissipation tube 52, and the other part of the liquid injection tube 55 passes through the opening 541 to extend to a side that is of the first protection plate 54 and that faces away from the heat dissipation tube 52.

In other words, the liquid injection tube 55 always passes through the opening 541 and extends to the side that is of the first protection plate 54 and that faces away from the heat dissipation tube 52. The cooling medium 512 can be injected into the gas-liquid channel 511 in the base plate 51 through liquid injection into the liquid injection tube 55. After the liquid injection is completed, a tube opening of the liquid injection tube 55 is sealed without adjusting the liquid injection tube 55 back to a position between the first protection plate 54 and the heat dissipation tube 52. In this example, a part of the liquid injection tube 55 is located between the first protection plate 54 and the heat dissipation tube 52, and the first protection plate 54 protects the part, so that a possibility of damage to the liquid injection tube 55 can also be reduced.

In addition, in this example, with reference to FIG. 13, the opening 541 may also extend to the edge of the first protection plate 54. In some other examples, the opening 541 may alternatively be located in a middle region of the first protection plate 54, as long as the opening 541 can allow the liquid injection tube 55 to pass through.

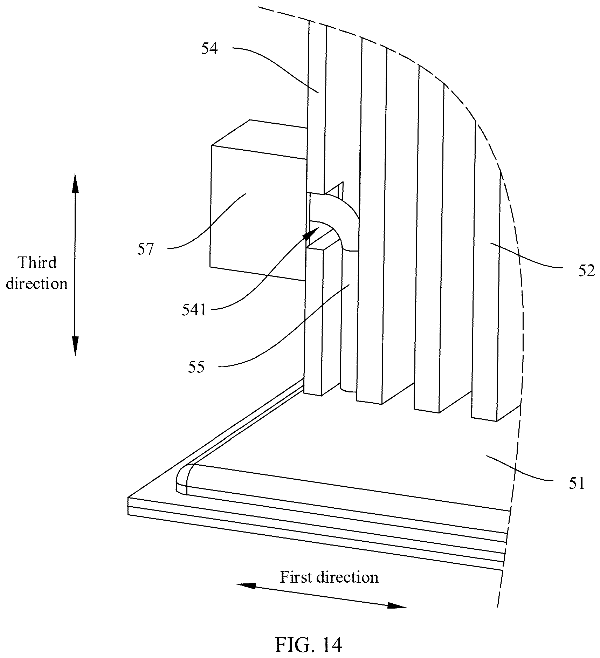

In the example in which the liquid injection tube 55 passes through the first protection plate 54, the heat dissipator 5 further includes a protective cover 57. FIG. 14 shows an example of a structure of the protective cover 57. The protective cover 57 is fastened to the first protection plate 54. The protective cover 57 is at least partially located on a side that is of the first protection plate 54 and that faces away from the heat dissipation tube 52. For example, in FIG. 14, the entire protective cover 57 is located on the side that is of the first protection plate 54 and that faces away from the heat dissipation tube 52, and a part that is of the liquid injection tube 55 and that extends to the side that is of the first protection plate 54 and that faces away from the heat dissipation tube 52 is located in the protective cover 57. In another example (not shown in the figures), one part of the protective cover 57 is located on the side that is of the first protection plate 54 and that faces away from the heat dissipation tube 52, and the other part is located between the first protection plate 54 and the heat dissipation tube 52. In this example, the protective cover 57 also covers the liquid injection tube 55, to protect the part that is of the liquid injection tube 55 and that extends to the side that is of the first protection plate 54 and that faces away from the heat dissipation tube 52.

The protective cover 57 may be fastened to the first protection plate 54 in any appropriate manner. For example, the protective cover 57 may be fastened to the first protection plate 54 by a screw, or the protective cover 57 may be fastened to the first protection plate 54 by bonding, welding, or snap fitting, or the protective cover 57 may be first snap-fitted to the first protection plate 54 and then reinforced by a bolt. This is not specifically limited in this application.

After the liquid injection is completed, a tube opening of the liquid injection tube 55 is sealed, the protective cover 57 is mounted on the first protection plate 54, and the part that is of the liquid injection tube 55 and that is located on the side that is of the first protection plate 54 and that faces away from the heat dissipation tube 52 is protected by the protective cover 57. In this way, the part that is of the liquid injection tube 55 and that is located between the first protection plate 54 and the heat dissipation tube 52 is protected by the first protection plate 54, and the part that is of the liquid injection tube 55 and that is located on the side that is of the first protection plate 54 and that faces away from the heat dissipation tube 52 is protected by the protective cover 57. The cooperation between the protective cover 57 and the first protection plate 54 further reduces a risk of damage to the liquid injection tube 55.

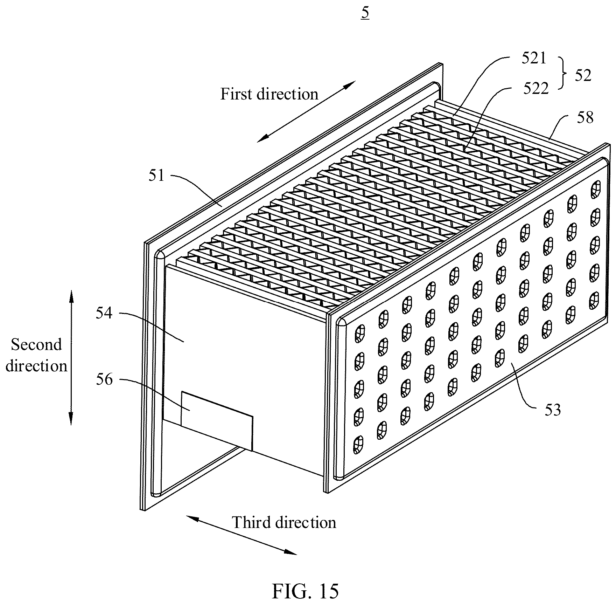

In some examples, the heat dissipator 5 further includes a second protection plate 58. FIG. 15 shows an example of a structure of the second protection plate 58. Refer to FIG. 15. The second protection plate 58 and the first protection plate 54 are fastened to the same plate surface of the base plate 51. The heat dissipation tube 52 is located between the first protection plate 54 and the second protection plate 58 in the first direction. In other words, the first protection plate 54 and the second protection plate 58 are located respectively on different sides of the heat dissipation tube 52 to protect the heat dissipation tube 52 together, reducing a possibility of damage to the heat dissipation tube 52. In addition, the first protection plate 54 can also provide protection for the liquid injection tube 55 when protecting the heat dissipation tube 52. The second protection plate 58 may be a hard plate. For example, the second protection plate 58 may be a metal plate, a plastic plate, or another solid plate structure.

Refer to FIG. 15. In an example in which the heat dissipation tube 52 includes a plurality of heat dissipation sub-tubes 521, the heat dissipation tube 52 may further include a plurality of second fins 522, the plurality of heat dissipation sub-tubes 521 are arranged in the first direction, a gap is provided between two adjacent heat dissipation sub-tubes 521, and the plurality of second fins 522 are fastened between at least two adjacent heat dissipation sub-tubes 521. For example, in the example shown in FIG. 15, a plurality of second fins 522 are fastened between every two adjacent heat dissipation sub-tubes 521. Gaps between the plurality of heat dissipation sub-tubes 521 can allow for efficient heat exchange between the heat dissipation tube 52 and air. In addition, the second fins 522 can help the heat dissipation sub-tubes 521 to dissipate heat. To be specific, heat of the heat dissipation sub-tubes 521 can be transferred to the second fins 522 and exchanged with outside air through the second fins 522, further improving heat dissipation efficiency of the heat dissipator 5.

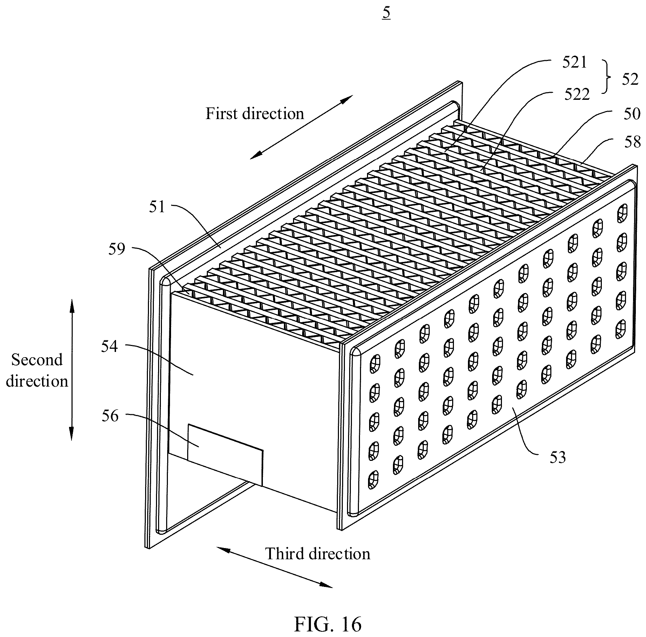

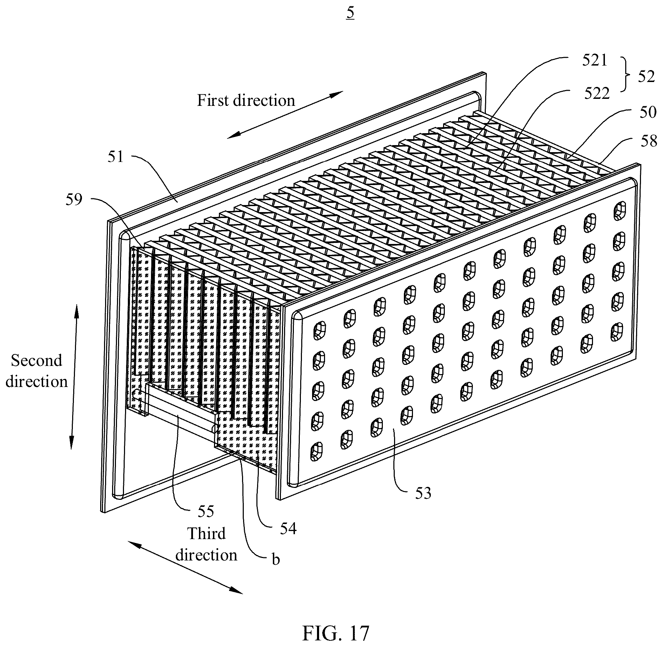

In some examples, fins may also be disposed between the first protection plate 54 and the heat dissipation tube 52. For example, the heat dissipator 5 further includes first fins 59. FIG. 16 shows an example of a structure of the first fins 59. Refer to FIG. 16. There may be a plurality of first fins 59, and the plurality of first fins 59 are fastened between the first protection plate 54 and the heat dissipation tube 52. Because the liquid injection tube 55 is disposed between the first protection plate 54 and the heat dissipation tube 52, the first fins 59 avoid the liquid injection tube 55. FIG. 17 shows an example of a position relationship between the first fins 59 and the liquid injection tube 55. The first protection plate 54 in FIG. 17 is indicated by shading. Refer to FIG. 17. The liquid injection tube 55 is close to an edge (for example, the edge b) of the first protection plate 54 in the second direction, and the first fins 59 are short in the second direction. In this case, a possibility of mutual interference between the first fins 59 and the liquid injection tube 55 can be reduced, facilitating assembly of the heat dissipator 5.

In some other examples, first fins 59 may be disposed on two sides of the liquid injection tube 55, and the liquid injection tube 55 is located between the first fins 59 on the two sides, so that the first fins 59 on the two sides avoid the liquid injection tube 55 located in the middle.

The first fins 59 are disposed between the first protection plate 54 and the heat dissipation tube 52. The first fins 59 can help the heat dissipation tube 52 to dissipate heat. To be specific, heat of the heat dissipation tube 52 and the first protection plate 54 can be transferred to the first fins 59 and exchanged with outside air through the first fins 59, further improving heat dissipation efficiency of the heat dissipator 5.

In addition, with reference to FIG. 17, in an example in which the heat dissipator 5 includes a second protection plate 58, a plurality of third fins 50 may also be disposed between the second protection plate 58 and the heat dissipation tube 52. To be specific, heat of the heat dissipation tube 52 and the second protection plate 58 can be transferred to the third fins 50 and exchanged with outside air through the third fins 50, further improving heat dissipation efficiency of the heat dissipator 5.

In some other examples, the heat dissipator 5 includes the first fins 59 and the third fins 50, but does not include the second fins 522. In some other examples, the heat dissipator 5 includes the first fins 59, but does not include the second fins 522 or the third fins 50.

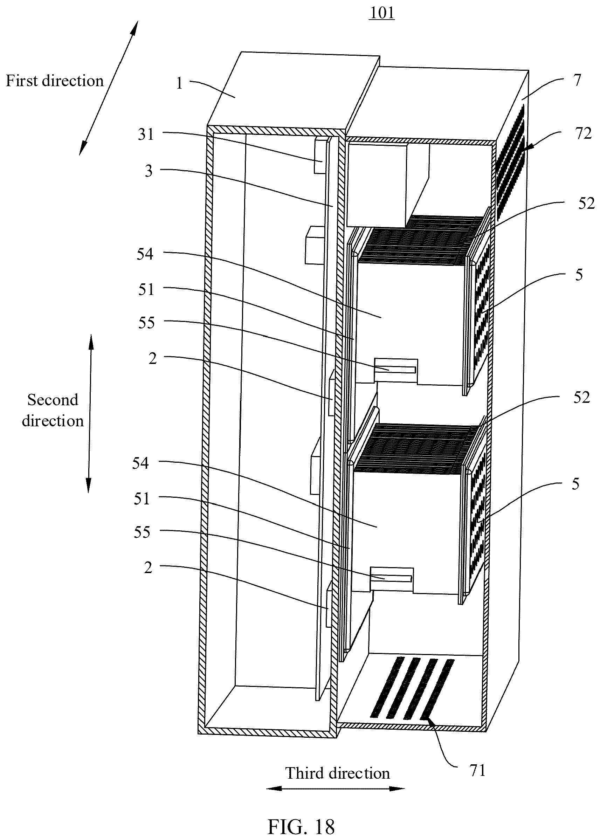

In some examples, the power conversion device 101 includes a plurality of heat dissipators 5. FIG. 18 shows an example of an internal structure of still another power conversion device 101. Refer to FIG. 18. The power conversion device 101 includes two heat dissipators 5, the two heat dissipators 5 are arranged in the second direction, and both the two heat dissipators 5 are located in space enclosed by a heat dissipation cover 7 and a housing 1. In this example, there are at least two power modules 2, and the at least two power modules 2 have a height difference in the second direction. A base plate 51 of each heat dissipator 5 is in contact with at least one power module 2. The two heat dissipators 5 dissipate heat from a plurality of power modules 2 with a height difference in the second direction.

In addition, with reference to FIG. 18, a liquid injection tube 55 is disposed between a first protection plate 54 and a heat dissipation tube 52 of each heat dissipator 5. In the example shown in FIG. 18, the liquid injection tube 55 is entirely located between the first protection plate 54 and the heat dissipation tube 52. In some other examples, the liquid injection tube 55 is not entirely located between the first protection plate 54 and the heat dissipation tube 52. Instead, one part of the liquid injection tube 55 is located between the first protection plate 54 and the heat dissipation tube 52, and the other part is located on a side that is of the first protection plate 54 and that faces away from the heat dissipation tube 52.

In some other examples (not shown in the figures), in a case that the power conversion device 101 includes a plurality of heat dissipators 5, the power conversion device 101 may also include a plurality of heat exchangers 4. The plurality of heat exchangers 4 are arranged in the second direction, and the plurality of heat exchangers 4 and the plurality of heat dissipators 5 are misaligned in the second direction.

When the power conversion device 101 is mounted at a specified position and is in a use state, the first direction and the thickness direction of the base plate 51 (the third direction) may be two horizontal directions that are perpendicular to each other, and the second direction may be a gravity direction (or a vertical direction).

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power conversion device, comprising a housing, a power module, and a heat dissipator, wherein the housing is configured to accommodate the power module, and the power module is configured to convert a direct current from a photovoltaic module or an energy storage battery into an alternating current;
the heat dissipator comprises a base plate, a heat dissipation tube, a first protection plate, and a liquid injection tube;
the base plate is fastened to the housing, a gas-liquid channel is provided in the base plate, a cooling medium for gas-liquid conversion is provided in the gas-liquid channel, the heat dissipation tube is fastened to a plate surface of the base plate, and an internal channel of the heat dissipation tube is in communication with the gas-liquid channel;
the housing has a mounting opening, the base plate and the heat dissipation tube are both located outside the housing, and the power module passes through the mounting opening to be in contact with a plate surface that is of the base plate and that faces away from the heat dissipation tube, or the base plate is located inside the housing and is in contact with the power module, and the heat dissipation tube passes through the mounting opening to extend out of the housing;
the first protection plate and the heat dissipation tube are fastened to the same plate surface of the base plate, the first protection plate and the heat dissipation tube are arranged in a first direction, and the first direction is perpendicular to a thickness direction of the base plate; and
an end of the liquid injection tube is fastened to the base plate, an internal channel of the liquid injection tube is in communication with the gas-liquid channel, and the liquid injection tube is at least partially located between the first protection plate and the heat dissipation tube.

2. The power conversion device according to claim 1, wherein the liquid injection tube is located between the first protection plate and the heat dissipation tube, the first protection plate has an opening, the opening passes through the first protection plate in the first direction, and the opening directly faces the liquid injection tube in the first direction.

3. The power conversion device according to claim 2, wherein a distance between the base plate and an edge that is of the opening and that faces away from the base plate is greater than a distance between the base plate and an end portion that is of the liquid injection tube and that faces away from the base plate.

4. The power conversion device according to claim 2 or 3, wherein the heat dissipator further comprises a baffle plate, the baffle plate is fastened to the first protection plate, and the baffle plate is configured to seal the opening.

5. The power conversion device according to claim 1, wherein the first protection plate has an opening, the opening passes through the first protection plate in the first direction, one part of the liquid injection tube is located between the first protection plate and the heat dissipation tube, and the other part of the liquid injection tube passes through the opening to extend to a side that is of the first protection plate and that faces away from the liquid injection tube.

6. The power conversion device according to claim 5, wherein the heat dissipator further comprises a protective cover, the protective cover is fastened to the first protection plate, the protective cover is at least partially located on a side that is of the first protection plate and that faces away from the heat dissipation tube, and the part that is of the liquid injection tube and that extends to the side that is of the first protection plate and that faces away from the liquid injection tube is located in the protective cover.

7. The power conversion device according to any one of claims 2 to 6, wherein the first protection plate has two opposite edges in a second direction, and the first direction, the second direction, and the thickness direction of the base plate are perpendicular to each other; and
the opening extends to one of the edges of the first protection plate, and the liquid injection tube is closer to the edge, from the two edges, at which the opening is provided.

8. The power conversion device according to any one of claims 1 to 7, wherein the heat dissipator further comprises first fins, the first fins are fastened between the first protection plate and the heat dissipation tube, and the first fins avoid the liquid injection tube.

9. The power conversion device according to any one of claims 1 to 8, wherein the heat dissipator further comprises a second protection plate, the second protection plate and the first protection plate are fastened to the same plate surface of the base plate, and the heat dissipation tube is located between the first protection plate and the second protection plate in the first direction.

10. The power conversion device according to any one of claims 1 to 9, wherein the heat dissipation tube comprises a plurality of heat dissipation sub-tubes and a plurality of second fins, the plurality of heat dissipation sub-tubes are arranged in the first direction, a gap is provided between two adjacent heat dissipation sub-tubes, the plurality of second fins are fastened between at least two adjacent heat dissipation sub-tubes, and the internal channel of the heat dissipation tube comprises an internal channel of each heat dissipation sub-tube.
